Europäisches Patentamt

(19) European Patent Office

Office européen des brevets

(11) Publication number : **0 136 869 B2**

# NEW EUROPEAN PATENT SPECIFICATION

(45) Date of publication of the new patent specification : 17.04.91 Bulletin 91/16

(51) Int. Cl.⁵ : **H01L 27/08,** // **H03M1/00**

(21) Application number : 84306406.4

(22) Date of filing : 19.09.84

(54) A resistance ladder network.

(30) Priority : 20.09.83 JP 173735/83

(43) Date of publication of application :
10.04.85 Bulletin 85/15

(45) Publication of the grant of the patent :
13.01.88 Bulletin 88/02

(45) Mention of the opposition decision :
17.04.91 Bulletin 91/16

(84) Designated Contracting States :
DE FR GB

(56) References cited :
EP-A- 0 016 605
EP-A- 0 035 361
DE-A- 2 256 595
DE-A- 2 354 567
JP-A- 553 604
JP-A- 553 605
US-A- 2 629 166
US-A- 3 601 745
US-A- 4 016 483
PATENTS ABSTRACTS OF JAPAN, vol. 4, no.
28(E-1)(510), 8th March 1980, page 161 E 1

(56) References cited :
Camenzind, Hans R., "Electronic Integrated
Systems Design", Van Nostrand Reinhold
Company, New York,1972, pp.59-67, 320
Proceedings of IFAC/IFIP Symposium, 12th to
23rd October 1965, R. Oldenbourg Verlag,
München, Wien, 1966, p. 320,Fig. 3 and p. 623,
Fig. 1a
Layout of Signalverarbeitungsteil CG 40S
Section from the Layout if Bosch 8-1 enlarged
x 1,5
ATZ Automobiltechnische Zeitschrift 84,
(1982), 2, pp. 77-83
Circuit Diagram of Airbag-Auslösegerät Y285
C 10 002

(73) Proprietor : FUJITSU LIMITED
1015, Kamikodanaka Nakahara-ku
Kawasaki-shi Kanagawa 211 (JP)

(72) Inventor : Hino, Youzi
2607, Suge Tama-ku
Kawasaki-shi Kanagawa 214 (JP)
Inventor : Ogawa, Hironobu
Fujitsu Shimonoge-ryo 878, Shimonoge
Takatsu-ku
Kawasaki-shi Kanagawa 213 (JP)

(74) Representative : Rackham, Stephen Neil et al
GILL JENNINGS & EVERY 53-64 Chancery
Lane
London WC2A 1HN (GB)

## Description

The present invention relates to a resistance ladder network, more particularly to an R-2R type or $2^n$-R type resistance ladder network.

Resistance ladder networks are commonly used in digital-to-analog (D/A) converters. The resistors of a resistance ladder network are normally diffusion resistors and thin film resistors. The diffusion resistors are formed by a number of short generally parallel strips. In the layout of the converter there are portions of the wiring which run parallel to the strips forming the resistors. Therefore, it is not possible to form another wiring layer extending over the diffused strips and generally perpendicular to the axis of the strips. If an insulation layer is formed above the wiring extending parallel to the strips, it is possible to form wiring on top of the insulation layer but this is not preferred since a two-layer aluminium wiring process is required and this increases the number of masks required for the manufacturing process. Thus, the yield rate decreases and the manufacturing process becomes more complex.

According to this invention, a resistance ladder network in an input portion of a D/A converter formed as an LSI circuit, comprises a plurality of resistors connected in a ladder format and arranged generally parallel to one another and transverse to a longitudinal direction of the network, each of the resistors having a resistance part, and two connection ends connected to the resistance part, and is characterised in that each resistor includes two side-by-side limbs, in that both the connection ends of each resistor are located on the one lateral side of the network, and in that conductor wirings inter-connecting the resistors are formed on a different substrate level from them and run generally lengthwise of the ladder network so that a space is provided on the same substrate level for other conductors superimposed on the resistors.

With the present invention, it is possible to use the resistance part of an R-2R type resistance ladder network and a $2^n$-R resistance ladder network as a passage for other wiring on the same level as the wiring forming the interconnections of the resistors. This is useful for improving the degree of integration of large-scale integrated circuits (LSI's).

Particular examples of ladder networks in accordance with this invention will now be described and contrasted with the prior art with reference to the accompanying drawings, in which :

Figure 1 is a circuit diagram of a R-2R type D/A converter ;
Figure 2 is a plan of the layout of a conventional R-2R type resistance ladder network ;
Figure 3 is a plan of a R-2R resistance ladder forming a first example of the present invention ;
Figures 4A to 4F are plans of various shapes of resistors ;

Figure 5 is a circuit diagram of a $2^n$-R type D/A converter ; and
Figure 6 is a plan of a $2^n$-R resistance ladder forming a second example of the present invention.

Before describing the preferred embodiments of the present invention, a detailed description will be given of the prior art for reference purposes.

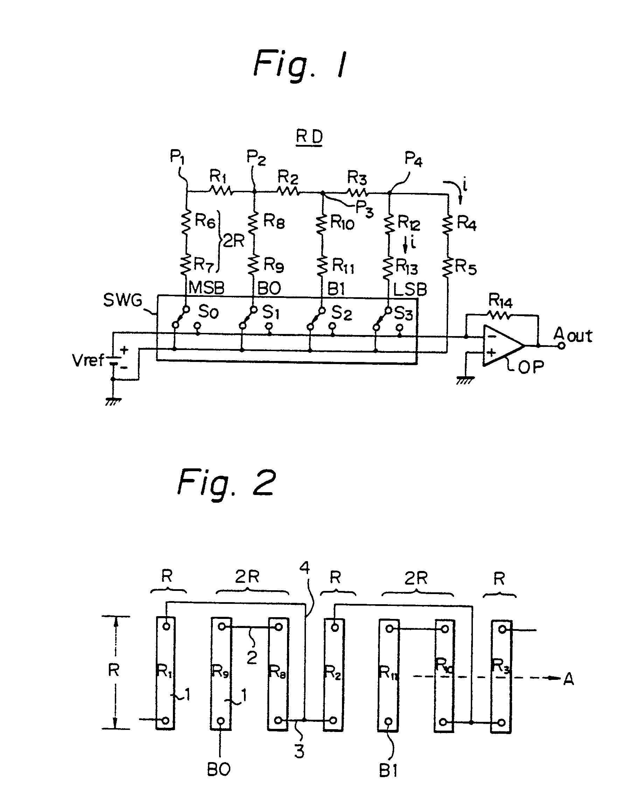

An R-2R type D/A converter which uses an R-2R type resistance ladder network is, as shown in the example schematically illustrated in Figure 1, comprised of an R-2R type resistance ladder network RD, switch group SWG, and operational amplifier OP for converting the output current to voltage. This example is a current-driven type. There is also a voltage-driven type.

The resistance ladder network RD includes five resistors $R_1$ to $R_5$ connected in series. One of the ends of the five resistors $R_1$ to $R_5$ are grounded ; the other of the ends $P_1$ are connected to a switch $S_0$ via two resistors $R_6$ and $R_7$. A junction point $P_2$ is connected to a switch 5, via two resistors $R_8$ and $R_9$, $P_3$ to a switch $S_2$ via two resistors $R_{10}$ and $R_{11}$, and $P_4$ to a switch $S_3$ via two resistors $R_{12}$ and $R_{13}$. The resistance value of each resistor $R_1$ to $R_{14}$ is the same.

In this circuit, the resistance value of the two resistors $R_4$ and $R_5$ connected to the ground is 2R. The resistance value of the two resistors $R_{12}$ and $R_{13}$ connected to the switch $S_3$ is also 2R. Since these two-resistor arms are parallel, the composite resistance value seen from point $P_4$ is R. Since these two-resistor arms are connected in series with the resistor $R_3$, the composite resistance value is 2R. Since this resistor circuit connected in series is connected in parallel with the two resistors $R_{10}$ and $R_{11}$, the composite resistance seen from the point $P_3$ is R. In the same way, in the circuit, seen from any point $P_1$, $P_2$, $P_3$, and $P_4$, two resistors are parallel, therefore, the composite resistance is R. The current flowing to each two resistors $R_6$ and $R_7$, $R_8$ and $R_9$, $R_{10}$ and $R_{11}$, and $R_{12}$ and $R_{13}$ is 8i, 4i, 2i, and i respectively. The switches $S_0$ to $S_4$ are switched to the left or the right in response to a digital input of 4 bits. As shown in Figure 1, when switched to the left side, connection is made to the inverting input-of the operational amplifier OP. When switched to the right side, connection is made to the noninverting input+side. The value of the current flowing to these inverting and noninverting inputs from $R_{ref}$ is determined by the digital input in accordance with the state of the switch. The analog output $A_{out}$ converting this to a voltage value becomes a D/A conversion value of the above digital input.

For the resistors of the R-2R type resistance ladder network RD, diffusion resistors or thin film resistors are normally used. Figure 2 is one example of this layout of the prior art, wherein the 1's are the diffusion resistors of resistance value R. The diffusion resistors 1 are formed in a short strip form and so that all are fairly parallel. Used individually, the resistance is R.

Used with two connected in series, the resistance becomes a resistance value 2R. Reference numeral 2 is wiring for forming the 2R resistors (for example, aluminium), 3 is wiring for connecting R and 2R, and 4 is wiring for successively connecting between $R_1$ and the junction point of $R_2$ and $R_8$.

The defect of this layout is that there must be a portion of wiring 4 parallel to the diffusion resistors 1, in other words a portion running from one end to the other of the diffusion resistor 3. Therefore, for example, it is not convenient to form another wiring layer horizontally traversing the diffusion layer in the arrow direction A.

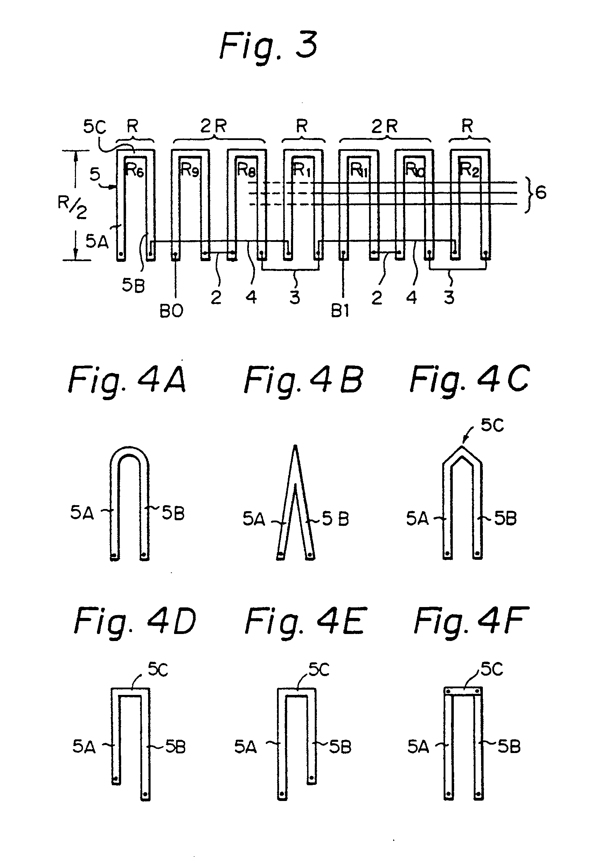

Figure 3 is a plan pattern diagram showing an embodiment of the present invention. This embodiment shows an R-2R type resistance ladder network. In the figure, 5 is a rectangular U-shaped diffusion resistor. This diffusion resistor 5 has a direct resistance value R comprising the total of one side 5A and the other side 5B and also the connection side 5C joining the ends of the two sides 5A and 5B. The connection side 5C may be an aluminium or other wiring layer of low resistance as shown in Figure 4F. In such a case, the resistance values of the sides 5A and 5B are each R/2. By making the basic diffusion resistor R of the R-2R type resistance ladder a rectangular U-shape, it is possible to gather all mutual connection ends on the same side. Reference numerals 2 to 4 are wiring as in Figure 2. Both are on one side of the rectangular U-shaped diffusion resistor. The mutual connection ends are connected at the same side without having to run the wiring parallel to the sides 5A and 5B. In this way, it is possible to form another wiring 6 horizontally traversing the sides 5A and 5B on the same level as the wiring 2 to 4, thereby enabling effective utilization of the chip area and improvement of the degree of integration.

Further, while it was said that the connection side 5C could be a low resistance wiring layer, if sides 5A and 5B are each R/2, it is possible to make the two slanted and joined in a V-shape and therefore eliminate the side SC, as shown in Figure 4B.

In another embodiment, the diffusion resistor may be U-shaped as shown in Figure 4A, the connection side 5C may be constructed by a V-shape diffusion layer as shown in Figure 4C.

In the above embodiments, the lengths of the sides 5A and 5B of the diffusion resistor 5 are the same as each other. However, in another embodiment, the side 5A may be shorter than the side 5B, as shown in Figure 4D, or longer than the side 5B, as shown in Figure 4E.

Regarding the overall area of the ladder network RD, in the case, for example, where R is set to 25 kiloohm in the layout of figure 2, if the sheet resistance of the diffusion layer is made ps = 1 kiloohm/square 10 $\mu$m × 1 kiloohm per 10 $\mu$m, the width W of the diffusion layer is 10 $\mu$m and the length is 250 $\mu$m. There-

fore, when forming an 8-bit D/A converter, since the number of diffusion layers reaches 25, the resistance covers about 400 $\mu$m in the horizontal direction, assuming a distance between resistances of 6 $\mu$m, and a considerable area (250 $\mu$m × 400 $\mu$m) is taken up by the ladder network. The area of the switch group SWG in this case is, with a complementary metal oxide semiconductor (CMOS), about 100 $\mu$m × 400 $\mu$m. Consequently if it is possible to pass other wiring through the ladder network RD, having a large area of twice or more of the same, a considerable improvement in the degree of integration can be expected. In the case of Figure 3 too, the same is true regarding area as with Figure 2.

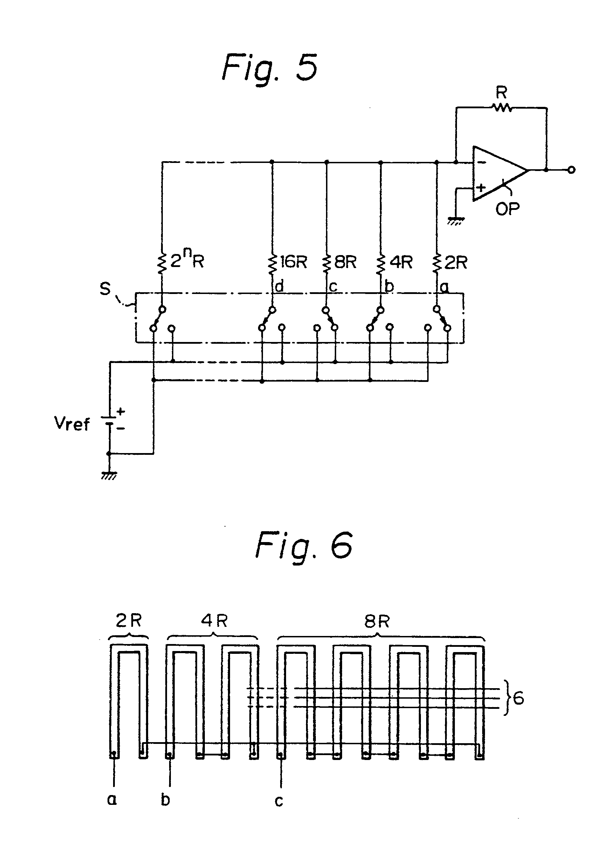

The present invention can also be applied to the $2^nR$ type D/A converter shown in Figure 5. In Figure 5, 2R, 4R,.... $2^nR$ are resistors, 5 is their switching circuit, $V_{ref}$ is the reference voltage, OP is an operational amplifier, and R is its feedback resistor.

Figure 6 is a plan pattern diagram showing another embodiment of the present invention. In the figure, each rectangular U-shaped diffusion resistor has the same constitution as that in Figure 3. The resistor 4R is composed by connecting in series two rectangular U-shaped diffusion resistors. The resistor 8R is composed by connecting in series four rectangular U-shaped diffusion resistors. The diffusion resistor shape may also be modified in this embodiment as shown in Figures 4A to 4F.

## Claims

1. A resistance ladder network (RD) in an input portion of a D/A converter formed as an LSI circuit, the resistance ladder (RD) comprising a plurality of resistors (5) connected in a ladder format and arranged generally parallel to one another and transverse to a longitudinal direction of the network, each of the resistors having a resistance part, and two connection ends connected to the resistance part, characterised in that each resistor includes two side-by-side limbs (5A and 5B), in that both the connection ends of each resistor are located on the one lateral side of the network, and in that conductor wirings (2, 3, 4) interconnecting the resistors (5) are formed on a different substrate level from them and run generally lengthwise of the ladder network (RD) so that a space is provided on the same substrate level for other conductors (6) superimposed on the resistors (5).

2. A resistance ladder network according to claim 1, wherein the resistance part of each resistor (5) comprises a continuous resistance element strip (Figure 4A-4E).

3. A resistance ladder network according to claim 1, wherein the resistance part of each resistor (5) comprises two straight resistance element strips and a conductive element (5C) connected between ends of the resistance element strips located at the other side of the network.

4. A resistance ladder network according to claim 2, wherein the continuous strip forming the resistance part of each resistor is U-shaped.

5. A resistance ladder network according to claim 2, wherein the continuous strip forming the resistance part of each resistor is V-shaped (Figure 4B).

6. A resistance ladder network according to any one of the preceding claims, wherein the lengths of the two limbs (5A and 5B) are equal to each other.

7. A resistance ladder network according to any one of claims 1 to 5, wherein the lengths of the two limbs (5A and 5B) are different from one another.

8. A resistance ladder network according to any one of the preceding claims, wherein the resistors (5) are connected in an R-2R ladder format.

9. A resistance ladder network according to any one of claims 1 to 7, wherein the resistors (5) are connected in a $2^n$-R ladder format.

## Ansprüche

1. Widerstandsleiternetzwerk (RD) in einem Eingangsabschnitt eines D/A-Konverters, der als eine LSI-Schaltung gebildet ist, welche Widerstandsleiter (RD) eine Vielzahl von Widerständen (5) umfaßt, die in einem Leiterformat verbunden und im allgemeinen parallel zueinander und quer zu einer Längsrichtung des Netzwerkes angeordnet sind, wobei jeder der Widerstände einen Widerstandsteil und zwei Verbindungsenden, die mit dem Widerstandsteil verbunden sind, hat, dadurch gekennzeichnet, daß jeder Widerstand zwei Seite an Seite liegende Glieder (5A, 5B) hat und daß beide Verbindungsenden jedes Widerstandes an einer Längsseite des Netzwerkes angeordnet sind, und daß die Leiterverdrahtungen (2, 3, 4), welche die Widerstände (5) untereinander verbinden, auf einem von ihnen verschiedenen Pegel gebildet sind und im allgemeinen in Längsrichtung des Leiternetzwerkes (RD) verlaufen, so daß ein Raum auf demselben Substratpegel für andere Leiter (6) vorgesehen ist, die den Widerständen (5) überlagert sind.

2. Widerstandsleiternetzwerk nach Anspruch 1, bei dem der Widerstandsteil von jedem Widerstand (5) einen kontinuierlichen Widerstandselementstreifen (Fig. 4A-4E) umfaßt.

3. Widerstandsleiternetzwerk nach Anspruch 1, bei dem der Widerstandsteil von jedem Widerstand (5) zwei gerade Widerstandselementstreifen und ein leitendes Element (5C) hat, das zwischen Enden des Widerstandselementstreifens angeschlossen ist, die an der anderen Seite des Netzwerkes angeordnet sind.

4. Widerstandsleiternetzwerk nach Anspruch 2, bei dem der kontinuierliche Streifen, der den Widerstandteil von jedem Widerstand bildet, U-förmig ist.

5. Widerstandsleiternetzwerk nach Anspruch 2, bei dem der kontinuierliche Streifen, der den Widerstandsteil von jedem Widerstand bildet, V-förmig ist (Fig. 4B).

6. Widerstandsleiternetzwerk nach einem der vorhergehenden Ansprüche, bei dem die Längen der beiden Glieder (5A und 5B) einander gleich sind.

7. Widerstandsleiternetzwerk nach einem der Ansprüche 1 bis 5, bei dem die Längen der beiden Glieder (5A und 5B) voneinander verschieden sind.

8. Widerstandsleiternetzwerk nach einem der vorhergehenden Ansprüche, bei dem die Widerstände (5) in einem R-2R-Leiterformat verbunden sind.

9. Widerstandsleiternetzwerk nach einem der Ansprüche 1 bis 7, bei dem die Widerstände (5) in einem $2^n$-R-Leiterformat verbunden sind.

## Revendications

1. Réseau en échelle de résistances (RD) disposé dans la partie d'entrée d'un convertisseur D/A se présentant sous la forme d'un circuit LSI, l'échelle de résistances (RD) comprenant plusieurs résistances (5) connectées suivant la forme d'une échelle et disposées sensiblement parallèlement les unes aux autres et transversalement à la direction longitudinale du réseau, chacune des résistances ayant une partie résistance et deux extrémités de connexion connectées à la partie résistance, caractérisé en ce que chaque résistance comporte deux branches disposées côte à côte (5A et 5B), en ce que les deux extrémités de connexion de chaque résistance sont placées sur le côté latéral du réseau et en ce que des câblages de conducteurs interconnectant les résistances sont formés sur un niveau de substrat différent d'elles et s'étendent sensiblement suivant la longueur du réseau en échelle de façon qu'un espace soit ménagé sur le même niveau de substrat pour d'autres conducteurs superposés aux résistances.

2. Réseau en échelle de résistances selon la revendication 1, où la partie résistance de chaque résistance (5) comprend une bande formant un élément de résistance continu (figures 4A à 4E).

3. Réseau en échelle de résistances selon la revendication 1, où la partie résistance de chaque résistance (5) comprend deux bandes formant des éléments de résistance rectilignes et un élément conducteur (5C) connecté entre les extrémités des bandes des éléments de résistance placées sur l'autre côté du réseau.

4. Réseau en échelle de résistances selon la revendication 2, où la bande continue formant la partie résistance de chaque résistance est en forme de U.

5. Réseau en échelle de résistances selon la revendication 2, où la bande continue formant la partie résistance de chaque résistance est en forme de U (figure 4B).

6. Réseau en échelle de résistances selon l'une quelconque des revendications précédentes, où les longueurs des deux branches (5A et 5B) sont égales entre elles.

7. Réseau en échelle de résistances selon l'une quelconque des revendications 1 à 5, ou les longueurs des deux branches (5A et 5B) sont différentes l'une de l'autre.

8. Réseau en échelle de résistances selon l'une quelconque des revendications précédentes, où les résistances (5) sont connectées sous la forme d'une échelle R-2R.

9. Réseau en échelle de résistances selon l'une quelconque des revendications 1 à 7, où les résistances (5) sont connectées suivant la forme d'une échelle $2^n$-R.

# Fig. 1

# Fig. 2

6

# Fig. 3

# Fig. 4A    Fig. 4B    Fig. 4C

# Fig. 4D    Fig. 4E    Fig. 4F

# Fig. 5

# Fig. 6